# EUROPÄISCHE PATENTSCHRIFT

(11) **EP 0 275 872 B1**
(45) Veröffentlichungstag und Bekanntmachung des Hinweises auf die Patenterteilung: **22.12.1993**
(21) Anmeldenummer: 88100076.4
(22) Anmeldetag: 05.01.1988
(51) Int. Cl.: G05F 3/20, H01L 27/02, H01L 27/08, H01L 27/06, H01L 23/58

(54) **Integrierte Schaltung mit "Latch-up" Schutzschaltung in komplementärer MOS Schaltungstechnik**
Integrated circuit with "latch-up" protective circuit in complementary MOS circuit techniques
Circuit intégré avec circuit de protection contre l'effet "latch-up" dans la technique des circuits MOS-complémentaires

(30) Priorität: 12.01.1987 DE 3700685
(43) Veröffentlichungstag der Anmeldung: 27.07.1988
(73) Patentinhaber: SIEMENS AKTIENGESELLSCHAFT, 80333 München (DE)
(72) Erfinder: Reczek, Werner, Dipl.-Ing., D-8012 Ottobrunn (DE); Winnerl, Josef, Dr. Ing., D-8300 Landshut (DE)

(56) Entgegenhaltungen:
- EP-A- 0 175 152
- EP-A- 0 202 074
- EP-A- 0 262 357

## Beschreibung

Die Erfindung bezieht sich auf eine integrierte Schaltung mit "Latch-up" Schutzschaltung in komplementärer MOS Schaltungstechnik nach dem Oberbegriff des Patentanspruchs 1.

Bei integrierten Schaltungen dieser Art in komplementärer MOS-Technologie liegt das Halbleitersubstrat nicht auf dem Massepotential der integrierten Schaltung, sondern es wird durch einen Substratvorspannungsgenerator negativ aufgeladen. Die Substratvorspannung des Substratvorspannungsgenerators verringert die Transistor- und Sperrschichtkapazitäten und verbessert die Schaltgeschwindigkeit. Bei einem Halbleitersubstrat aus p-leitendem Material, das mit einer eingefügten n-leitenden wannenförmigen Halbleiterzone versehen ist, handelt es sich dabei um eine negative Substratvorspannung von etwa -2 bis -3 Volt. Die Sourcegebiete von Feldeffekttransistoren, die außerhalb der wannenförmigen Halbleiterzone auf dem Halbleitersubstrat vorgesehen sind, sind hierbei auf das Massepotential gelegt.

Im Moment des Einschaltens der positiven Versorgungsspannung befindet sich das betrachtete p-leitende Halbleitersubstrat zunächst in einem Zustand des "floating", in dem es von äußeren Potentialen freigeschaltet ist.

Dieser Zustand wird durch das Wirksamwerden des Substratvorspannungsgenerators beendet. Die Zeitspanne zwischen dem Einschalten der Versorgungsspannung und dem Wirksamwerden des Substratvorspannungsgenerators wird im wesentlichen durch die Taktfrequenz, vorhandene Koppelkapazitäten und die vorhandene kapazitive Last beeinflußt. In der Zeit des "floating" kann das Halbleitersubstrat über die Sperrschichtkapazitäten, die einerseits zwischen der wannenförmigen Halbleiterzone und dem Substrat und andererseits zwischen den mit dem Massepotential belegten Sourcegebieten und dem Substrat vorhanden sind, vorübergehend auf eine positive Vorspannung aufgeladen werden, die erst beim Wirksamwerden des Substratvorspannungsgenerators wieder abgebaut und durch die sich am Ausgang desselben allmählich aufbauende negative Substratvorspannung ersetzt wird. Aber auch im Betrieb der integrierten Schaltung können größere Ströme, die vom Halbleitersubstrat über den Substratvorspannungsgenerator zu einem auf Massepotential liegenden Anschluß des letzteren abgeleitet werden, durch den Spannungsabfall am Innenwiderstand des Substratvorspannungsgenerators zu einer positiven Vorspannung des Halbleitersubstrats führen. Positive Vorspannungen stellen aber ein hohes Sicherheitsrisiko für die integrierte Schaltung dar, da ein "Latch-up"-Effekt ausgelöst werden kann, der im allgemeinen den Ausfall der integrierten Schaltung bedeutet.

Zum Verständnis des "Latch-up"-Effekts kann man davon ausgehen, daß zwischen einem Anschluß eines in der wannenförmigen Halbleiterzone liegenden Feldeffekttransistors des ersten Kanaltyps und einem Anschluß eines außerhalb dieser Zone auf dem Halbleitersubstrat plazierten Feldeffekttransistors des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmige Halbleiterzone die zweite, das Halbleitersubstrat die dritte und das eine Anschlußgebiet des letzten Transistors die vierte Halbleiterschicht bilden. Aufgrund dieses Aufbaus ergeben sich ein parasitärer bipolarer pnp- und ein npn-Transistor. Der Kollektor des pnp-Transistors entspricht der Basis des npn-Transistors und die Basis des pnp-Transistors dem Kollektor des npn-Transistors. Diese Struktur bildet eine Vierschichtdiode pnpn wie bei einem Thyristor. Bei einer positiven Vorspannung des Halbleitersubstrats kann der pn-Übergang zwischen der dritten und vierten Halbleiterschicht soweit in Durchlaßrichtung vorgespannt werden, daß zwischen den genannten Transistoranschlüssen ein Strompfad entsteht, der auf eine parasitäre Thyristorwirkung innerhalb dieser Vierschichtenstruktur zurückzuführen ist. Der Strompfad bleibt dann auch nach einem Abbau der positiven Substratvorspannung bestehen und kann die integrierte Schaltung thermisch überlasten.

Es ist bekannt, daß zur Verringerung der Transistor- und Sperrschichtkapazitäten eine negative Substratvorspannung in der NMOS-Technik verwendet wird, die über einen sogenannten Substratvorspannungsgenerator auf der integrierten Schaltung erzeugt wird (siehe Buchreihe Halbleiterelektronik, 14, H. Weiß, K. Horninger "Integrierte MOS-Schaltungen", Seite 247-248). Der "Latch-up"-Effekt bei positiven Halbleitersubstratspannungen ist ebenfalls in diesem Fachbuch auf den Seiten 111-112 beschrieben. Als Abhilfe werden hier eine Änderung der Technologie (Dotierungsprofile) oder Maßnahmen beim Entwurf (Wannenabstände) vorgeschlagen. Ein anderer Losungsvorschlag, den Latch-up-Effekt zu unterbinden, ist in der Veröffentlichung D. Takacs et al. "Static and transient latch-up hardness in n-well CMOS with on-chip substrate bias generator", IEDM 85, Technical Digest, Seite 504 bis 508, dargestellt. Es wird hierin eine Klemmschaltung vorgeschlagen, die einen "Latch-up"-Effekt dadurch verhindert, indem das Halbleitersubstratpotential auf einen Wert begrenzt wird, der nicht ausreicht, die parasitären Bipolartransistoren im Halbleitersubstrat zu aktivieren. Die Klemmschaltung muß dazu die hohen kapazitiven Ladeströme nach Masse abführen.

Durch die oben angegebene Klemmschaltung wird prinzipiell nicht die Möglichkeit der positiven Aufladung des Halbleitersubstrats ausgeschlossen, sondern es werden lediglich seine Auswirkungen dadurch kompensiert, daß, falls eine positive Aufladung des Halbleitersubstrats erfolgt ist, eine niederohmige Masseverbindung die positive Aufladung wieder abbaut.

Aus der europäischen Patentanmeldung EP-A-0,202,074 ist eine Schaltung nach dem Oberbegriff des Patentanspruchs 1 bekannt, bei der jedoch der Ausgang der elektronischen Schutzschaltung nicht nur mit einer ersten Kondensatorfläche des Kondensators, sondern auch mit einem Dotierungsgebiet eines MOS-Transistors verbunden ist und die zweite Kondensatorfläche des Kondensators auf Bezugspotential gelegt ist.

Aus der europäischen Patentanmeldung EP-A-0,175,152 ist eine Vorrichtung zur Vermeidung von Latch-up in CMOS-Anordnungen bekannt, bei der eine Versorgungsspannung erst dann anlegbar ist, wenn ein Halbleitersubstrat durch einen ersten Vorspannungsgenerator und/oder eine Wanne durch einen zweiten Vorspannungsgenerator vorgespannt sind.

Der Erfindung liegt die Aufgabe zugrunde, eine Schaltung der eingangs genannten Art anzugeben, bei der das Auftreten von "Latch-up"-Effekten weitgehend vermieden wird. Das wird erfindungsgemäß durch eine Ausbildung der Schaltung nach dem kennzeichnenden Teil des Patentanspruchs 1 erreicht.

Die Patentansprüche 2 bis 11 sind auf bevorzugte Ausgestaltungen und Weiterbildungen der Erfindung gerichtet. Der Patentanspruch 12 betrifft eine bevorzugte Anwendung der Erfindung.

Der mit der Erfindung erzielbare Vorteil liegt insbesondere darin, daß eine unerwünscht hohe Aufladung des Halbleitersubstrats, die einen "Latch-up"-Effekt auslösen kann, mit einfachen Mitteln auf einen Wert begrenzt wird, der diese Gefahr ausschließt.

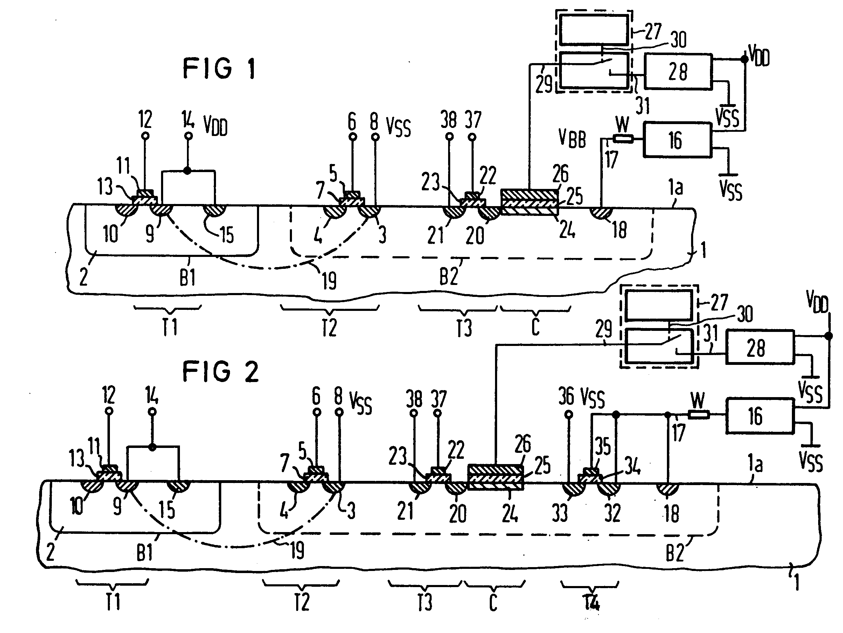

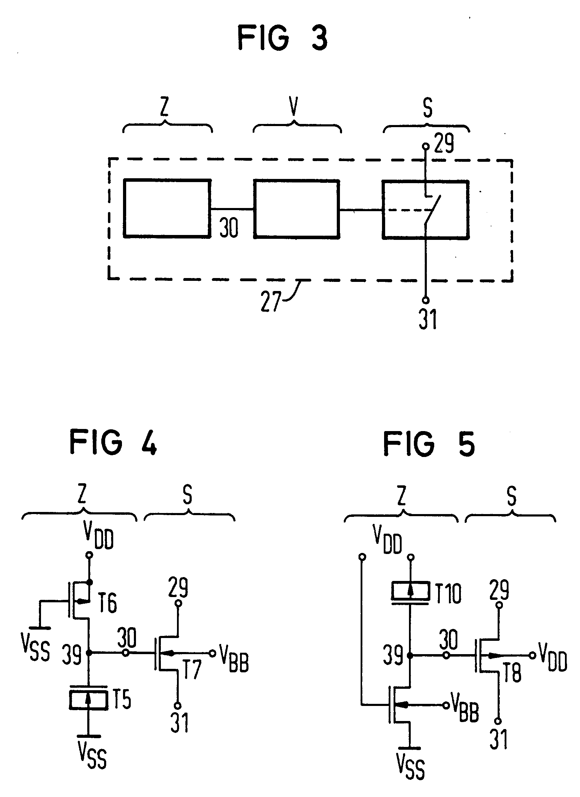

Zwei Ausführungsbeispiele der Erfindung sind in den Zeichnungen in Figur 1 und Figur 2 dargestellt und werden im folgenden näher beschrieben. Es zeigt
- Figur 1: eine integrierte Schaltung mit "Latch-up" Schutzschaltung in CMOS Schaltungstechnik mit einer Eintransistorspeicherzelle,
- Figur 2: eine integrierte Schaltung mit "Latch-up" Schutzschaltung wie Figur 1, zusätzlich ausgestattet mit einer Klemmschaltung,
- Figur 3: eine Prinzipschaltung einer "Latch-up" Schutzschaltung,
- Figur 4, 5: Ausführungsbeispiele für eine "Latch-up" Schutzschaltung mit ohm'scher Last,
In Figur 1 ist eine erfindungsgemäße integrierte Schaltung mit "Latch-up" Schutzschaltung dargestellt, die auf einem Halbleitersubstrat 1 aus dotiertem Halbleitermaterial, zum Beispiel p-leitendem Silizium, aufgebaut ist. Das Halbleitersubstrat 1 weist eine n-leitende, wannenförmige Halbleiterzone 2 auf, die sich bis zur Grenzfläche 1a des Halbleitersubstrats 1 hin erstreckt. Außerhalb der Halbleiterzone 2 sind in das Halbleitersubstrat n⁺-dotierte Halbleitergebiete 3, 4, 20 und 21 eingefügt, die die Source-und Draingebiete zweier n-Kanal-Feldeffekttransistoren T2 und T3 bilden. Der Kondensator C, der beliebig ausgebildet sein kann, besteht in diesem Fall aus einer planaren Dielektrikumschicht 25, einer planaren Polysiliziumschicht 26 und einer n-dotierten Schicht 24 und bildet zusammen mit dem n-Kanal-Feldeffekttransistor T3 eine Eintransistorspeicherzelle, in die Informationen abgelegt oder aus der Informationen ausgelesen werden können. Der zwischen 3 und 4 bzw. 20 und 21 liegende Kanalbereich wird von einem Gate 5 bzw. 22 überdeckt, das mit einem Anschluß 6 bzw. 37 versehen ist und durch eine dünne elektrisch isolierende Schicht 7 bzw. 23, z.B. aus SiO₂, von der Grenzfläche 1a getrennt ist. Das Draingebiet 21 ist mit dem Anschluß 38 verbunden, während das Sourcegebiet 3 mit dem auf Massepotential V_{SS} liegenden Anschluß 8 verschaltet ist. Weiterhin sind in die Halbleiterzone 2 p⁺-dotierte Gebiete 9 und 10 eingefügt, welche das Source- und das Draingebiet eines p-Kanal-Feldeffekttransistors T1 darstellen. Der zwischen den Gebieten 9 und liegende Kanalbereich wird von einem Gate 11 überdeckt, das mit einem Anschluß 12 versehen ist und durch eine dünne elektrisch isolierende Schicht 13, zum Beispiel aus SiO₂, von der Grenzfläche 1a getrennt ist. Das Sourcegebiet 9 vom Feldeffekttransistor T1 ist mit einem Anschluß 14 verbunden, der mit einem Versorgungspotential V_{DD} beschaltet ist. Über ein n⁺-dotiertes Kontaktgebiet 15, das mit dem Anschluß 14 in Verbindung steht, liegt die Halbleiterzone 2 auf der Versorgungsspannung V_{DD}.

Weiterhin ist ein Substratvorspannungsgenerator 16 vorgesehen, der eine negative Substratvorspannung von zum Beispiel -2 bis -3 Volt erzeugt und seinerseits an Masse V_{SS} und an die Versorgungsspannung V_{DD} angeschlossen ist. Der Ausgang 17 des Substratvorspannungsgenerators ist mit einem p⁺-dotierten Substratspannungsanschluß 18 verbunden, der in das Halbleitersubstrat 1 eingefügt ist. Damit befindet sich das Halbleitersubstrat 1 auf der durch 16 erzeugten negativen Substratvorspannung V_{BB}, während sich die Sourcegebiete, zum Beispiel 3, der im Halbleitersubstrat 1 befindlichen Transistoren, zum Beispiel T2, auf Massepotential V_{SS} befinden. Hierdurch wird unter anderem erreicht, daß die Sperrschichtkapazitäten der Drain- und Sourcegebiete der im Halbleitersubstrat 1 angeordneten Transistoren verkleinert werden. Zur Vermeidung eines " Latch-up"-Effekts, der entlang der gestrichelten Linie 19 liegenden Vierschichtstruktur 3, 1, 2 und 9 zwischen den Anschlüssen 8 und 14 auftreten kann, werden die kapazitiven Ladeströme des Kondensators C durch die elektronische Schutzschaltung 27 nach dem Einschalten für eine Zeitdauer ΔT unterbrochen, bis das Substrat negativ aufgeladen ist, so daß kein "Latch-up" ausgelöst wird. In der elektronischen Schutzschaltung 27 wird beim Einschalten der integrierten Schaltung der Eingang 31 elektrisch mit dem Ausgang 29, der an einer Kondensatorfläche 26 des Kondensators C angeschlossen ist, erst nach einer Zeitverzögerung ΔT miteinander verbunden. Der Eingang 31 ist an einen Vorspannungsgenerator 28 für den Kondensator angeschlossen, der seinerseits mit Masse V_{SS} und mit der Versorgungsspannung V_{DD} verbunden ist. Die Ausgangsspannung des Vorspannungsgenerators kann beispielsweise die Hälfte der Versorgungsspannung, also V_{DD}/2 betragen. Beim Einschalten der integrierten Schaltung bewirkt die elektronische Schutzschaltung eine Unterbrechung zwischen dem Eingang 31 und dem Ausgang 29. Dies bedeutet, daß die kapazitiven Ladeströme vom Vorspannungsgenerator 28 auf den Kondensator C für eine Zeit ΔT nach Anlegen von V_{DD} unterbunden werden. Im Normalbetrieb bzw. nach der Zeit ΔT liegt die Kondensatorfläche 26 niederohmig über die elektronische Schutzschaltung 27 am Vorspannungsgenerator 28 für den Kondensator.

In Figur 2 ist ein zweites Ausführungsbeispiel der Erfindung dargestellt, das sich von Figur 1 durch eine zusätzliche Klemmschaltung unterscheidet. Der Ausgang 17 des Substratvorspannungsgenerators 16 ist hierzu über einen elektronischen Schalter, hier ein Feldeffekttransistor T4, mit einem Schaltungspunkt verbunden, der sich auf Massepotential V_{SS} befindet. Beim dargestellten Ausführungsbeispiel handelt es sich bei diesem Schaltungspunkt um den Anschluß 36. Im einzelnen ist der Ausgang 17 bei der Anordnung nach Fig.2 mit einem n⁺-dotierten Halbleitergebiet 32 verbunden, das in das Halbleitersubstrat 1 eingefügt ist. Ein weiteres n⁺-dotiertes, in das Halbleitersubstrat 1 eingefügtes Halbleitergebiet 33 ist mit dem auf Massepotential V_{SS} liegenden Schaltungspunkt, das heißt mit dem Anschluß 36 verbunden. Der zwischen den Gebieten 32 und 33 liegende Bereich des Halbleitersubstrats 1 ist von einem Gate 35 überdeckt, das durch eine dünne elektrisch isolierende Schicht 34, zum Beispiel aus SiO₂, von der Grenzfläche 1a getrennt ist. Die Gebiete 32 und 33 bilden zusammen mit den Teilen 34 und 35 einen n-Kanal-Feldeffektschalttransistor T4. Die Ansteuerung von T4 erfolgt über den Knoten 17.

Der Schalttransistor 32 bis 35 in Figur 2 soll eine niedrige Einsatzspannung haben, die kleiner ist als die Durchlaßspannung des pn-Übergangs zwischen 1 und 3. Das ist in der herkömmlichen Weise zum Beispiel dadurch zu erreichen, daß der zwischen den Gebieten 32 und 33 liegende Bereich des Halbleitersubstrats 1 außer der Grunddotierung, die zum Beispiel 10¹⁵cm⁻³ beträgt, keine zusätzliche Dotierung aufweist, während die Kanalbereiche der übrigen Feldeffekttransistoren, zum Beispiel T2, in der Nähe der Grenzfläche 1a mit einer zusätzlichen, die Grunddotierung verstärkenden Dotierung versehen sind, die zweckmäßigerweise im Wege einer Implantation mit einer Dosis von etwa 10¹²cm⁻² eingebracht wird. Sind in der verwendeten Herstellungstechnik zwei verschiedene Isolierschichtdicken verfügbar, so wird für 34 zweckmäßigerweise die kleinere verwendet, die zum Beispiel 15 nm beträgt, während für die Schicht 7 und 13 eine Dicke von etwa 20 bis 25 nm gewählt wird. Liegt das Halbleitersubstrat 1 auf einer positiven Vorspannung, was beispielsweise beim Anschalten der Versorgungsspannung V_{DD} auftritt, wenn der Substratvorspannungsgenerator 16 noch nicht die volle negative Spannung hat, wie dies in Figur 1 schon erläutert wurde, so ist auch das Gate 35 entsprechend positiv vorgespannt, was bei Überschreiten der niedrigen Einsatzspannung dazu führt, daß der Schalttransistor 32 bis 35 leitet. Damit wird dann die Spannung am Knoten 17 auf den Wert der niedrigen Einsatzspannung begrenzt.

Während die elektronische Schutzschaltung durch eine Unterbrechung des kapazitiven Ladestromes des Kondensators C für eine Zeit ΔT nach dem Einschalten eine positive Aufladung durch diesen Ladestrom am Halbleitersubstrat 1 verhindert, wirkt die zusätzliche Klemmschaltung allen übrigen Möglichkeiten der positiven Substrataufladung entgegen. Ergeben sich beispielsweise im Betrieb große Ströme, die über das Halbleitersubstrat 1 und die Teile 18, 17, 16 nach Masse V_{SS} abfließen, so kann am Innenwiderstand W von 16 ein solcher Spannungsabfall entstehen, daß der Ausgang 17 und damit das Halbleitersubstrat 1 zumindest vorübergehend auf eine positive Vorspannung gelangt. In diesem Falle werden diese Ströme über die zusätzliche Klemmschaltung abgeführt.

Der Substratvorspannungsgenerator 16, die elektronische Schutzschaltung 27 sowie der Vorspannungsgenerator 28 für den Kondensator der Figuren 1 und 2 sind zweckmäßigerweise auf dem Halbleitersubstrat mit aufintegriert.

In Figur 3 ist eine Prinzipschaltung der elektronischen Schutzschaltung 27 angegeben. Sie besteht aus drei Einzelkomponenten, einem Zeitglied Z, einem Verstärker V und einem elektronischen Schalter S mit einem Eingang 31 und einem Ausgang 29. Beim Einschalten der integrierten Schaltung gibt das Zeitglied Z am Ausgang 30 ein Signal ab, das bewirkt, daß der Eingang 31 und der Ausgang 29 im elektrischen Schalter S elektrisch voneinander getrennt werden. Nach einer Zeitdauer ΔT gibt der Zeitschalter ein Signal ab, so daß im elektronischen Schalter S der Eingang und der Ausgang 29 wieder miteinander verbunden werden. Der Verstärker V ist wahlweise einzubauen, je nach der erforderlichen Anpassung des Ausgangssignals des Zeitglieds Z an den elektronischen Schalter S.

Zwei Ausführungsbeispiele für eine elektronische Schutzschaltung 27 mit ohm'scher Last sind in den Figuren 4 und 5 dargestellt. Sie bestehen lediglich aus zwei Komponenten, einem Zeitglied Z und einem elektronischen Schalter S.

In Figur 4 ist für das Zeitglied Z eine Serienschaltung eines n-Kanal-Feldeffekttransistors T5, der einen Kondensator bildet und eines ohm'schen Lastelements vorgesehen, das insbesondere durch einen p-Kanal-Feldeffekttransistor T6 gebildet wird, dessen Substrat mit seinem Sourceanschluß verbunden ist. Das Gate des Feldeffekttransistors T6 ist dabei mit der Masse V_{SS} verbunden. Der eine Anschluß der Serienschaltung ist auf die Versorgungsspannung V_{DD} gelegt und mit dem Sourceanschluß des Feldeffekttransistors T6 verschaltet, während der andere Anschluß auf Masse V_{SS} liegt und mit dem Source-Drain- und Substratanschluß des Feldeffekttransistors T5 verbunden ist. Den Ausgang 30 des Zeitgliedes bilden den Gateanschluß des Feldeffekttransistors T5 und den Drainanschluß des Feldeffekttransistors T6. Der elektronische Schalter S ist durch einen n-Kanal-Feldeffekttransistor T7 realisiert. Source- und Drainanschluß bilden jeweils den Ausgang 29 und den Eingang 31 der elektronischen Schutzschaltung 27. Der Verbindungspunkt 39 ist an das Gate des n-Kanal-Feldeffekttransistors T7 angeschlossen, während der Substratanschluß des Feldeffekttransistors T7 auf eine negative Spannug V_{BB} gelegt ist.

Der Verbindungspunkt 39 in Figur 4 liegt über die beim Einschalten leere Kapazität auf Masse V_{SS}, so daß der Feldeffekttransistor T7 sperrt und die Verbindung zwischen dem Eingang 31 und dem Ausgang 29 ist unterbrochen. Wenn die Kapazität nach einer Zeitdauer ΔT aufgeladen ist und die Spannung am Verbindungspunkt 39 größer/gleich der Summe aus der Spannung am Eingang 31 des Feldeffekttransistors T7 und der Einsatzspannung deselben Feldeffekttransistors ist, wird der n-Kanal-Feldeffekttransistor leitend und verbindet den Eingang 31 mit dem Ausgang 29. Im Betrieb ist der Kondensator aufgeladen und die elektronische Schutzschaltung in Figur 4 ist querstromfrei.

Figur 5 zeigt eine Schaltungsvariante zu Figur 4, mit einem p-Kanal Feldeffekttransistor T8 als elektronischen Schalter S. Das Zeitglied Z ist wiederum durch eine Serienschaltung, und zwar aus einem p-Kanal Feldeffekttransistor T10, der als Kondensator verschaltet ist, und aus einem ohm'schen Lastelement realisiert. Das ohm'sche Lastelement, in diesem Falle ein n-Kanal Feldeffekttransistor T9, ist mit seinem Gateanschluß auf die Versorgungsspannung V_{DD} und mit seinem Substratanschluß auf eine negative Spannung V_{BB} gelegt. Der eine Anschluß der Serienschaltung ist mit der Masse V_{SS} verbunden, der andere Anschluß, der durch den Substrat-Source-und Drainanschluß des Feldeffekttransistors T10 gebildet ist, ist auf die Versorgungsspannung V_{DD} gelegt. Der Verbindungspunkt 39 und der Ausgang 30 des Zeitgliedes ist an das Gate des p-Kanal-Feldeffekttransistors T8 angeschlossen, während der Substratanschluß des Feldeffekttransistors T8 mit einer positiven Spannung V_{DD} verschaltet ist. Source- und Drainanschluß von Feldeffekttransistor T8 bilden jeweils den Eingang 31 und den Ausgang 29 der elektronischen Schutzschaltung.

Die Funktionsweise der Schaltung in Figur 5 ist analog der zur Schaltung in Figur 4. Solange der Kondensator ungeladen ist, sperrt der Feldeffekttransistor T8. Nach einer Zeitdauer ΔT, gemessen ab dem Einschaltzeitpunkt der integrierten Schaltung, ist der Kondensator aufgeladen und die Spannung am Verbindungspunkt 39 ist kleiner/gleich der Summe aus der Spannung am Eingang 31 des Feldeffekttransitors T8 und der Einsatzspannung derselben. Ab diesem Zeitpunkt leitet der Feldeffekttransistor T8 und verbindet den Eingang 31 mit dem Ausgang 29. Im Betrieb ist der Kondensator aufgeladen und die elektronische Schutzschaltung ist in Figur 5 querstromfrei.

Neben den oben behandelten Ausführungsformen umfaßt die Erfindung auch solche, bei denen n-leitendes Substrat mit p-leitenden wannenförmigen Halbleiterzonen versehen ist. Dabei werden die Leitungstypen sämtlicher Halbleiterteile und die Polaritäten sämtlicher Spannungen durch die jeweils entgegengesetzten ersetzt.

Weiterhin werden auch solche Ausführungsformen von der Erfindung erfaßt, die sich aus Figur 1 und Figur 2 durch folgende Abänderungen ergeben. Die Begrenzungslinie B1 fällt weg, wobei diese beiden Teile nunmehr als n-leitendes Substrat aufzufassen sind. Hiervon ausgehend wird dann in dieses n-leitende Substrat eine p-leitende wannenförmige Halbleiterzone eingefügt, die durch die gestrichelte Linie B2 gegen das n-leitende Substrat abgegrenzt ist und die Schaltungsteile T2, T3, C, T4 und 18 enthält.

Eine bevorzugte Anwendung der Erfindung ergibt sich für die Peripherieschaltungen von dynamischen Halbleiterspeichern großer Packungsdichte, die mit den Speicherzellen monolithisch integriert sind.

### Bezugszeichenliste

- 1: Halbleitersubstrat
- 1a: Grenzfläche des Halbleitersubstrats
- 2: wannenförmige Halbleiterzone
- 3, 4, 20, 21, 15, 32, 33 n⁺: dotierte Halbleitergebiete
- 5, 11, 22, 35: Gateelektroden
- 6, 12, 37: Gateanschluß
- 7, 13, 23, 34: Isolierschicht zwischen Gateanschluß und Gateelektrode
- 8, 14, 38, 36: Drain- bzw. Sourceanschluß
- 9, 10, 18 p⁺: dotierte Halbleitergebiete
- 16: Substratvorspannungsgenerator
- 17: Ausgang des Substratvorspannungsgenerators
- 19: gestrichelte Linie zur Vierschichtstruktur
- 24: n-dotierte Schicht des Kondensators C
- 25: planare Dielektrikumsschicht des Kondensators C
- 26: planare Polysiliziumschicht des Kondensators C
- 27: Latch-up Schutzschaltung
- 28: Vorspannungsgenerator
- 29: Ausgang der Latch-up Schutzschaltung
- 30: Ausgang des Zeitgliedes
- 31: Eingang der Latch-up Schutzschaltung
- V_{BB}: Substratvorspannung
- V_{DD}: Versorgungsspannung
- V_{SS}: Masse
- W: Innenwiderstand des Substratvorspannungsgenerators
- B1, B2: Begrenzungslinien
- T1, T2, T3, T4, T5, T6, T7, T8, T9, T10: Transistoren
- C: Kondensator
- Z: Zeitglied
- V: Verstärker
- S: elektronischer Schalter
- 39: Verbindungspunkt zwischen elektronischem Schalter S und Komparator K

## Patentansprüche

1. Integrierte Schaltung mit "Latch-up"-Schutzschaltung in komplementärer MOS-Schaltungstechnik
- mit einem in einem dotierten Halbleitersubstrat (1) angeordneten Substratvorspannungsanschluß (18), der an einem Ausgang (17) eines Substratvorspannungsgenerators angeschlossen ist,
- mit einer elektronischen Schutzschaltung (27), die beim Einschalten der integrierten Schaltung ihren Ausgang (29) um die Zeit ΔT verzögert mit einem Vorspannungsgenerator (28) verbindet, und
- mit einem Kondensator (C), der mit dem Ausgang (29) der elektronischen Schutzschaltung (27) und einem Dotierungsgebiet (20) eines MOS-Transistors (T3) verbunden ist,
**dadurch gekennzeichnet,**
- daß eine erste Kondensatorfläche (24) des Kondensators (C) in das Halbleitersubstrat integriert und mit dem Dotierungsgebiet des MOS-Transistors (T3) verbunden ist und
- daß eine zweite Kondensatorfläche (26) des Kondensators (C) nur mit dem Ausgang der elektronischen Schutzschaltung (27) verbunden ist.

2. Integrierte Schaltung nach Anspruch 1, **dadurch gekennzeichnet,** daß das Halbleitersubstrat (1) eines ersten Leitungstyps durch eine wannenförmige Halbleiterzone des ersten Leitungstyps ersetzt wird und daß die wannenförmige Halbleiterzone (2) eines zweiten Leitungstyps durch ein Halbleitersubstrat des zweiten Leitungstyps ersetzt wird und daß die wannenförmige Halbleiterzone des ersten Leitungstyps in das Halbleitersubstrat des zweiten Leitungstyps eingefügt ist.

3. Integrierte Schaltung nach Anspruch 1 oder 2, **dadurch gekennzeichnet,** daß die elektronische Schutzschaltung (27) ein Zeitglied (Z), einen Verstärker (V) und einen elektronischen Schalter (S) enthält.

4. Integrierte Schaltung nach Anspruch 3, **dadurch gekennzeichnet,** daß das Zeitglied (Z) eine Serienschaltung eines Lastelements und eines ersten Feldeffekttransistors (T5) enthält, daß ein erster Anschluß dieser Serienschaltung, der zugleich einen Anschluß des Lastelements darstellt, mit einer positiven Spannung (V_{DD}) beschaltet ist, daß der zweite Anschluß dieser Serienschaltung, der zugleich einen Source- und Drain-Anschluß des ersten Feldeffekttransistors (T5) und einen Substratanschluß desselben Feldeffekttransistors darstellt, mit Massepotential (V_{SS}) verbunden ist.

5. Integrierte Schaltung nach Anspruch 4, **dadurch gekennzeichnet,** daß der elektronische Schalter (S) einen n-Kanal-Feldeffekttransistor (T7) enthält und ein Gate-Anschluß des n-Kanal-Feldeffekttransistors (T7) mit einem Verbindungspunkt (39) des ersten Feldeffekttransistors (T5) und des Lastelements der Serienschaltung verbunden ist, daß ein Substratanschluß des Feldeffekttransistors (T7) mit einer negativen Spannung (V_{BB}) verschaltet ist, daß ein Source-Anschluß des Feldeffekttransistors (T7) mit der zweiten Kodensatorfläche (26) und ein Drain-Anschluß des Feldeffekttransistors (T7) mit dem Vorspannungsgenerator (28) für den Kondensator verbunden ist.

6. Integrierte Schaltung nach einem der Ansprüche 4 oder 5, **dadurch gekennzeichnet,** daß das Lastelement durch einen zweiten Feldeffekttransistor (T6) anderen Kanaltyps als der erste Feldeffekttransistor (T5) realisiert ist, daß ein Gate-Anschluß des Feldeffekttransistors (T6) mit Massepotential (V_{SS}) verbunden ist und ein Substratanschluß des Feldeffekttransistors (T6) mit einer positiven Spannung (V_{DD}) verbunden ist.

7. Integrierte Schaltung nach Anspruch 3, **dadurch gekennzeichnet,** daß das Zeitglied (Z) eine Serienschaltung eines Lastelements und eines Feldeffekttransistors (T10) enthält, daß ein erster Anschluß dieser Serienschaltung, der zugleich mit dem Source-Drain und Substratanschluß des Feldeffekttransistsors (T10) verbunden ist, mit einer positiven Spannung (V_{DD}) beschaltet ist, daß der zweite Anschluß dieser Serienschaltung, der zugleich einen Anschluß des Lastelements darstellt, mit Massepotential (V_{SS}) verbunden ist.

8. Integrierte Schaltung nach Anspruch 7, **dadurch gekennzeichnet,** daß der elektronische Schalter (S) einen p-Kanal Feldeffekttransistor (T8) enthält und ein Gate-Anschluß des p-Kanal Feldeffekttransistors (T8) mit einem Verbindungspunkt (39) des Feldeffekttransistors (T10) und des Lastelements der Serienschaltung verbunden ist, daß ein Substratanschluß des Feldeffekttransistors (T8) mit einer positiven Spannung (V_{DD}) verschaltet ist, daß ein Drain-Anschluß des Feldeffekttransistors (T8) mit der zweiten Kondensatorfläche (26) und ein Source-Anschluß des Feldeffekttransistors (T8) mit dem Vorspannungsgenerator (28) für den Kondensator verbunden ist.

9. Integrierte Schaltung nach einem der Ansprüche 7 oder 8, **dadurch gekennzeichnet,** daß das Lastelement durch einen Feldeffekttransistor (T9) anderen Kanaltyps als der Feldeffekttransistor (T10) realisiert ist und daß ein Gate-Anschluß des Feldeffekttransistors (T9) mit einer positiven Spannung (V_{DD}) und der Substratanschluß des Feldeffekttransistors (T9) mit einer negativen Spannung V_{BB} verbunden ist.

10. Integrierte Schaltung nach einem der Ansprüche 1 bis 9, **dadurch gekennzeichnet,** daß der Ausgang (17) des Substratvorspannungsgenerators (16) über einen elektronischen Schalter (T4) mit einem auf Massepotential (V_{SS}) liegenden Schaltungspunkt (36) verbunden ist und daß der elektronische Schalter (T4) über eine am Substratvorspannungsanschluß (18) abgegriffene Spannung angesteuert wird.

11. Integrierte Schaltung nach einem der Ansprüche 1 bis 10, **dadurch gekennzeichnet,** daß der Substratvorspannungsgenerator (16), der Vorspannungsgenerator (28) für den Kondensator, die elektronische Schutzschaltung (27) und der elektronische Schalter (T4) auf dem Halbleitersubstrat mit aufintegriert sind.

12. Integrierte Schaltung nach einem der vorhergehenden Ansprüche, **gekennzeichnet durch** die Anwendung als Peripherieschaltung für dynamische Halbleiterspeicher hoher Integrationsdichte.

## Claims

1. Integrated circuit with "latch-up" protective circuit in complementary MOS circuit technology,
- comprising a substrate bias terminal (18) which is disposed in a doped semiconductor substrate (1) and which is connected to an output (17) of a substrate bias generator,
- comprising an electronic protective circuit (27) which, when the integrated circuit is turned on, connects its output (29) to a bias generator (28) with a time delay of ΔT, and
- comprising a capacitor (C) which is connected to the output (29) of the electronic protective circuit (27) and a doping [sic] region (20) of an MOS transistor (T3),
characterized
- in that a first capacitor surface (24) of the capacitor (C) is integrated in the semiconductor substrate and is connected to the doping [sic] region of the MOS transistor (T3), and
- in that a second capacitor surface (26) of the capacitor (C) is connected only to the output of the electronic protective circuit (27).

2. Integrated circuit according to Claim 1, characterized in that the semiconductor substrate (1) of a first conduction type is replaced by a well-shaped semiconductor zone of the first conduction type, and in that the well-shaped semiconductor zone (2) of a second conduction type is replaced by a semiconductor substrate of the second conduction type, and in that the well-shaped semiconductor zone of the first conduction type is inserted in the semiconductor substrate of the second conduction type.

3. Integrated circuit according to Claim 1 or 2, characterized in that the electronic protective circuit (27) contains a timing element (Z), an amplifier (V) and an electronic switch (S).

4. Integrated circuit according to Claim 3, characterized in that the timing element (Z) contains a series connection of a load element and a first field-effect transistor (T5), in that a positive voltage (V_{DD)} is applied to a first terminal of said series connection, which terminal is also a terminal of the load element, and in that the second terminal of said series connection, which terminal is also a source terminal and a drain terminal of the first field-effect transistor (T5) and a substrate terminal of the same field-effect transistor, is connected to earth potential (V_{SS}).

5. Integrated circuit according to Claim 4, characterized in that the electronic switch (S) contains an n-channel field-effect transistor (T7) and a gate terminal of the n-channel field-effect transistor (T7) is connected to a connection point (39) of the first field-effect transistor (T5) and of the load element of the series connection, in that a substrate connection of the field-effect transistor (T7) is connected to a negative voltage (V_{BB}), and in that a source terminal of the field-effect transistor (T7) is connected to the second capacitor surface (26) and a drain terminal of the field-effect transistor (T7) is connected to the capacitor bias generator (28).

6. Integrated circuit according to one of Claims 4 or 5, characterized in that the load element of a second field-effect transistor (T6) is formed by a second field-effect transistor (T6) of a channel type other than the first field-effect transistor (T5), and in that a gate terminal of the field-effect transistor (T6) is connected to earth potential (V_{SS}) and a substrate terminal of the field-effect transistor (T6) is connected to a positive voltage (V_{DD}).

7. Integrated circuit according to Claim 3, characterized in that the timing element (Z) contains a series connection of a load element and a field-effect transistor (T10), in that a positive voltage (V_{DD}) is applied to a first terminal of said series connection, which is also connected to the source-drain and substrate terminal of the field-effect transistor (T10), and in that the second terminal of said series connection, which is also a terminal of the load element, is connected to earth potential (V_{SS}).

8. Integrated circuit according to Claim 7, characterized in that the electronic switch (S) contains a p-channel field-effect transistor (T8) and a gate terminal of the p-channel field-effect transistor (T8) is connected to a connection point (39) of the field-effect transistor (T10) and of the load element of the series connection, in that a positive voltage (V_{DD}) is applied to a substrate terminal of the field-effect transistor (T8), and in that a drain terminal of the field-effect transistor (T8) is connected to the second capacitor surface (26) and a source terminal of the field-effect transistor (T8) is connected to the capacitor bias generator (28).

9. Integrated circuit according to either of Claims 7 or 8, characterized in that the load element is formed by a field-effect transistor (T9) of a channel type other than the field-effect transistor (T10), and in that a gate terminal of the field-effect transistor (T9) is connected to a positive voltage (V_{DD}) and the substrate terminal of the field-effect transistor (T9) is connected to a negative voltage (V_{BB}).

10. Integrated circuit according to one of Claims 1 to 9, characterized in that the output (17) of the substrate bias generator (16) is connected via an electronic switch (T4) to a circuit point (36) which is at earth potential (V_{SS}), and in that the electronic switch (T4) is driven by means of a voltage tapped off at the substrate bias terminal (18).

11. Integrated circuit according to one of Claims 1 to 10, characterized in that the substrate bias generator (16), the capacitor bias generator (28), the electronic protective circuit (27) and the electronic switch (T4) are also integrated on the semiconductor substrate.

12. Integrated circuit according to one of the preceding claims, characterized by the use as peripheral circuit for dynamic semiconductor memories having high integration density.

## Revendications

1. Circuit intégré comportant un circuit de protection "Latch-up" réalisé selon la technique des circuits MOS complémentaires, comportant
- une borne (18) d'application de la tension de polarisation de substrat, qui est disposée dans un substrat semiconducteur dopé (1) et est raccordée à une sortie (17) d'un générateur de tension de polarisation de substrat,
- un circuit de protection électronique (27), qui, lors de l'activation du circuit intégré, raccorde la sortie (29) de ce circuit à un générateur de tension de polarisation (28) avec un retard d'une valeur ΔT, et
- un condensateur (C), qui est connecté à la sortie (29) du circuit de protection électronique (27) et à une région dopée (20) d'un transistor MOS (T3),
caractérisé par le fait
- qu'une première surface (24) du condensateur (C) est intégrée dans le substrat à semiconducteurs et est connectée à la région dopée du transistor MOS (T3), et
- qu'une seconde surface (26) du condensateur (C) est connectée uniquement à la sortie du circuit de protection électronique (27).

2. Circuit intégré suivant la revendication 1, caractérisé par le fait que le substrat semiconducteur (1) possédant un premier type de conductivité est remplacé par une zone semiconductrice en forme de cuvette possédant le premier type de conductivité et que la zone semiconductrice en forme de cuvette (2) possédant un second type de conductivité est remplacée par un substrat semiconducteur possédant le second type de conductivité, et que la zone semiconductrice en forme de cuvette possédant le premier type de conductivité est insérée dans le substrat semiconducteur possédant le second type de conductivité.

3. Circuit intégré suivant la revendication 1 ou 2, caractérisé par le fait que le circuit de protection électronique (27) comporte un circuit de temporisation (Z), un amplificateur (V) et un interrupteur électronique (S).

4. Circuit intégré suivant la revendication 3, caractérisé par le fait que le circuit de temporisation (Z) comporte un circuit série formé d'un élément de charge et d'un premier transistor à effet de champ (T5), qu'une première borne de ce circuit série, qui représente simultanément une borne de l'élément de charge, est placée à une tension positive (V_{DD}), que la seconde borne de ce circuit série, qui représente simultanément une borne de source et de drain du premier transistor à effet de champ (T5) et une borne de substrat de ce même transistor à effet de champ, est placée au potentiel de masse (V_{SS}).

5. Circuit intégré suivant la revendication 4, caractérisé par le fait que l'interrupteur électronique (S) comporte un transistor à effet de champ à canal n (T7) et qu'une borne de grille du transistor à effet de champ à canal n (T7) est raccordée à un point de jonction (39) du premier transistor à effet de champ (T5) et de l'élément de charge du circuit série, qu'une borne de substrat du transistor à effet de champ (T7) est placée à une tension négative (V_{BB}), qu'une borne de source du transistor à effet de champ (T7) est connectée à la seconde surface (26) du condensateur et qu'une borne de drain du transistor à effet de champ (T7) est reliée au générateur de tension de polarisation (28) pour le condensateur.

6. Circuit intégré suivant l'une des revendications 4 ou 5, caractérisé par le fait que l'élément de charge est constitué par un second transistor à effet de champ (T6) possédant un autre type de canal que le premier transistor à effet de champ (T5), et qu'une borne de grille du transistor à effet de champ (T6) est placée au potentiel de masse (V_{SS}) et qu'une borne de substrat du transistor à effet de champ (T6) est placée à une tension positive (V_{DD}).

7. Circuit intégré suivant la revendication 3, caractérisé par le fait que le circuit de temporisation (Z) comporte un circuit série formé d'un élément de charge et d'un transistor à effet de champ (T10), qu'une première borne de ce circuit série, qui est raccordée simultanément à la source, au drain et à la borne de substrat du transistor à effet de champ (T10), est placée une tension positive (V_{DD}), et que la seconde borne de ce circuit série, qui représente simultanément une borne de l'élément de charge, est placée au potentiel de masse (V_{SS}).

8. Circuit intégré suivant la revendication 7, caractérisé par le fait que l'interrupteur électronique (S) comporte un transistor à effet de champ à canal p (T8) et qu'une borne de grille du transistor à effet de champ à canal p (T8) est raccordé à un point de jonction (39) du transistor à effet de champ (T10) et de l'élément de charge du circuit série, qu'une borne de substrat du transistor à effet de champ (T8) est raccordée à une tension positive (V_{DD}), qu'une borne de drain du transistor à effet de champ (T8) est raccordée à la seconde surface (26) du condensateur et qu'une borne de source du transistor à effet de champ (T8) est raccordée au générateur de tension de polarisation (28) pour le condensateur.

9. Circuit intégré suivant l'une des revendications 7 ou 8, caractérisé par le fait que l'élément de charge est constitué par un transistor à effet de champ (T9) possédant un autre type de canal que le transistor à effet de champ (T10), et qu'une borne de grille du transistor à effet de champ (T9) est placée à une tension positive (V_{DD}) et que la borne de substrat du transistor à effet de champ (T9) est placée à une tension négative V_{BB}.

10. Circuit intégré suivant l'une des revendications 1 à 9, caractérisé par le fait que la sortie (17) du générateur de tension de polarisation de substrat (16) est raccordée, par l'intermédiaire d'un interrupteur électronique (T4), à un point (36) du circuit placé au potentiel de masse (V_{SS}), et que l'interrupteur électronique (T4) est commandé par l'intermédiaire d'une tension prélevée sur la borne (18) délivrant la tension de polarisation de substrat.

11. Circuit intégré suivant l'une des revendications 1 à 10, caractérisé par le fait que le générateur de tension de polarisation de substrat (16), le générateur de tension de polarisation (28) pour le condensateur, le circuit de protection électronique (27) et l'interrupteur électronique (T4) sont intégrés simulanément sur le substrat semiconducteur.

12. Circuit intégré suivant l'une des revendications précédentes, caractérisé par son utilisation en tant que circuit périphérique pour des mémoires dynamiques à semiconducteurs à haute densité d'intégration.
